# EUROPÄISCHE PATENTANMELDUNG

(11) **EP 2 380 479 A1**
(43) Veröffentlichungstag der Anmeldung: **26.10.2011**
(21) Anmeldenummer: 10401060.8
(22) Anmeldetag: 23.04.2010
(51) Int. Cl.: A47L 15/42, D06F 39/00, F24C 15/04, F24C 7/08, H03K 17/96

(54) **Bedieneinrichtung für Haushaltgeräte wie Herde, Dampfgarer, Wäschebehandlungs- oder Spülmaschinen.**

(71) Anmelder: Miele & Cie. KG, 33332 Gütersloh (DE)
(72) Erfinder: Herbst, Christof, 33442 Herzebrock-Clarholz (DE)

(57) **Zusammenfassung**

Die Erfindung betrifft eine Bedieneinrichtung (1) für Haushaltgeräte, wie Herde, Dampfgarer, Wäschebehandlungs- oder Spülmaschinen, die als Griff ausgebildet und frontseitig an einer zum Verschließen einer Beschickungsöffnung des Herdes, des Dampfgarers, der Wäschebehandlungs- oder Spülmaschine vorgesehenen Tür (2) anordbar ist. Um eine Bedieneinrichtung (1) dahingehend weiterzuentwickeln, dass bei gleichzeitiger Bedienfreundlichkeit eine vereinfachte Reinigung ermöglicht ist, wird mit der Erfindung eine Bedieneinrichtung (1) mit einem Gehäuse (3) und einer Gehäusekappe (4) aus Edelstahl vorgeschlagen, wobei das Gehäuse (3) von der Gehäusekappe (4) bedienerseitig abgedeckte Bedienelemente (11) bereitstellt, die als berührungsempfindliche Bedienelemente (11) ausgebildet sind.

## Beschreibung

Die Erfindung betrifft eine Bedieneinrichtung für Haushaltgeräte, wie Herde, Dampfgarer, Wäschebehandlungs- oder Spülmaschinen, die als Griff ausgebildet und frontseitig an einer zum Verschließen einer Beschickungsöffnung des Herdes, des Dampfgarers, der Wäschebehandlungs- oder Spülmaschine vorgesehenen Tür anordbar ist.

Bedieneinrichtungen für Haushaltgeräte, wie Herde, Dampfgarer, Wäschebehandlungs- oder Spülmaschinen im Allgemeinen sowie solche im Speziellen, die als Griff ausgebildet und frontseitig an einer Tür eines Herdes, eines Dampfgarers, einer Wäschebehandlungs- oder Spülmaschine angeordnet sind, sind aus dem Stand der Technik an sich bekannt, weshalb es eines gesonderten druckschriftlichen Nachweises an dieser Stelle nicht bedarf.

Obgleich sich vorbekannte Bedieneinrichtungen im alltäglichen Praxiseinsatz bewährt haben, sind diese nicht frei von Nachteilen. So hat sich beispielsweise bei Bedieneinrichtungen mit herausstehenden Bedientasten als störend herausgestellt, dass eine Reinigung des Bedienfeldes, insbesondere der Bereiche zwischen beabstandeten Bedientasten, nicht ohne weiteres möglich ist. Auch bei mit Klebfolien abgedeckten Drucktasten ergeben sich im alltäglichen Praxiseinsatz Nachteile, da sich die Klebfolien bei der sogenannten Wischdesinfektion verdrehen und sogar ablösen können.

Um die Wischdesinfektion gewährleisten zu können, sind aus dem Stand der Technik auch Taster bekannt geworden, die mit einer PE-Folie überklebt sind. Im Randbereich der Bedieneinrichtung ist diese Folie von einem Kunststoffrahmen umfasst, womit ein ungewolltes Ablösen der Folie unterbunden ist. An der folienseitigen Randkante des Kunststoffrahmens können sich aber in nachteiliger Weise Verschmutzungen und damit Keime ansammeln, die sich durch eine einfache Wischdesinfektion nicht entfernen lassen. Ein erhöhter Reinigungsaufwand ist in nachteiliger Weise die Folge.

Obgleich Bedieneinrichtungen der vorgenannten Art wohlbekannt sind, besteht in Anbetracht der vorerläuterten Nachteile Verbesserungsbedarf, insbesondere dahingehend, eine vereinfachte Reinigungsmöglichkeit zu gewährleisten.

Es ist deshalb die Aufgabe der Erfindung, eine Bedieneinrichtung der eingangs genannten Art dahingehend weiterzuentwickeln, dass bei gleichzeitiger Bedienfreundlichkeit eine vereinfachte Reinigung ermöglicht ist.

Zur Lösung dieser Aufgabe wird mit der Erfindung eine Bedieneinrichtung für Haushaltgeräte, wie Herde, Dampfgarer, Wäschebehandlungs- oder Spülmaschinen vorgeschlagen, die als Griff ausgebildet und frontseitig an einer zum Verschließen einer Beschickungsöffnung des Haushaltgerätes vorgesehenen Tür anordbar ist, mit einem Gehäuse und einer Gehäusekappe aus Edelstahl, wobei das Gehäuse von der Gehäusekappe bedienerseitig abgedeckte Bedienelemente bereitstellt, die als berührungsempfindliche Bedienelemente ausgebildet sind.

Die erfindungsgemäße Bedieneinrichtung, die auch als Bedienpult bezeichnet werden kann, ist als Griff mit einem frontseitig vorgesehenen Bedienfeld ausgebildet. Die Bedieneinrichtung stellt insofern eine aus Bedienfeld und Griff kombinierte Baueinheit dar. Im endmontierten Zustand ist die Bedieneinrichtung frontseitig an einer zum Verschließen einer Beschickungsöffnung des Herdes, des Dampfgarers, der Wäschebehandlungs- oder Spülmaschine vorgesehenen Tür angeordnet und kann zum Verschwenken der Tür bedienerseitig ergriffen werden.

Die Bedieneinrichtung weist ein Gehäuse und eine Gehäusekappe auf. Dabei ist die Gehäusekappe erfindungsgemäß aus Edelstahl ausgebildet. Der Vorteil von Edelstahl gegenüber beispielsweise Kunststoff ist insbesondere in der Unempfindlichkeit gegen herkömmliche Reinigungs-, Putz- und Desinfektionsmitteln zu sehen.

Das Gehäuse der erfindungsgemäßen Bedieneinrichtung stellt im bestimmungsgemäßen Verwendungsfall von einem Bediener zu betätigende Bedienelemente bereit. Diese sind erfindungsgemäß als berührungsempfindliche Bedienelemente ausgebildet und von der aus Edelstahl gebildeten Gehäusekappe bedienerseitig abgedeckt. Diese Ausgestaltung hat den Vorteil, dass die Bedieneinrichtung frontseitig quasi eben ausgebildet ist, das heißt vorspringende oder zurückspringende Kanten, an denen sich Verschmutzungen und/oder Keime ansammeln könnten, sind vollends vermieden.

Die auch als "Touch"-Bedienelemente zu bezeichnenden Bedienelemente nach der Erfindung sind von der Gehäusekappe vollends abgedeckt, womit die dem vorerläuterten Stand der Technik anhaftenden Nachteile vollends überwunden sind. Es besteht im Unterschied zu den aus dem Stand der Technik bekannten Lösungen insbesondere nicht die Gefahr, dass es infolge einer Wischdesinfektion zu Beschädigungen kommt und/oder dass sich ungewollt Verschmutzungen oder Keime ansammeln. Mit der erfindungsgemäßen Ausgestaltung wird vielmehr eine Bedieneinrichtung mit einem Bedienfeld vorgeschlagen, das bedienerseitig eine glatte Oberfläche bereitstellt, die sehr gut und ohne Rückstände gereinigt werden kann und die aufgrund des eingesetzten Edelstahlmaterials darüber hinaus beständig gegen alle Arten von chemischen Reinigern und/oder Desinfektionsmitteln ist.

Das Gehäuse der erfindungsgemäßen Bedieneinrichtung verfügt gemäß einem weiteren Vorschlag der Erfindung über einen Aufnahmeraum, der der Aufnahme von Teilen der Bedienelemente, von Elektronikbauteilen und/oder dergleichen dient. Das Gehäuse kann beispielsweise als Kunststoffspritzgussteil ausgebildet sein, in welches der Aufnahmeraum einstückig eingeformt ist. Als Elektronikbauteil kommt insbesondere eine Leiterplatte mit Display und Steuerelektronik in Frage. Diese wird in den vom Gehäuse bereitgestellten Aufnahmeraum eingesetzt und dort lagefixiert, vorzugsweise verschraubt und/oder verklebt.

Als Bedienelemente können insbesondere piezoelektrische oder kapazitive Bedienelemente zum Einsatz kommen, die in der Regel aus einem Berührungsfeld auf der Edelstahloberfläche und einem dahinter angeordneten Sensor bestehen. Die Sensoren sind vorzugsweise gleichfalls auf der vorgenannten Leiterplatte angeordnet.

Im endmontierten Zustand sind das Gehäuse und die vom Aufnahmeraum des Gehäuses aufgenommenen Bedienelemente und Elektronikbauteile von der Gehäusekappe schützend und flüssigkeitsdicht abgedeckt. Eine Betätigung der berührungsempfindlich ausgebildeten Bedienelemente erfolgt durch eine einfache Berührung der bedienerseitigen Oberfläche der Edelstahl-Gehäusekappe.

Die Gehäusekappe verfügt gemäß einem weiteren Merkmal der Erfindung frontseitig über eine Ausnehmung. In dieser Ausnehmung ist überstandsfrei ein Display, vorzugsweise ein Anzeigendisplay angeordnet. Dieses Anzeigendisplay kann von der schon vorerläuterten Leiterplatte getragen sein.

Die Anordnung des Anzeigendisplays in der Ausnehmung erbringt den Vorteil, dass bedienerseitig ein bündiger Abschluss zur Edelstahl-Gehäusekappe ausgebildet ist. Die unerwünschte Ansammlung von Verschmutzungen und/oder Keimen ist so wirkungsvoll unterbunden.

Die Gehäusekappe deckt gemäß einem weiteren Merkmal der Erfindung das Gehäuse sowohl front- als auch randseitig zumindest teilweise ab. Auch diese Maßnahme dient dazu, für die Ansammlung von Verschmutzungen und/oder Keimen anfällige Kanten, Vorsprünge und/oder dergleichen zu vermeiden. Die Gehäusekappe besitzt einen bedienerseitigen Frontabschnitt. Dieser dient der frontseitigen Abdeckung des Gehäuses. Einstückig mit diesem bedienerseitigen Frontabschnitt ist ein Randabschnitt verbunden, der der randseitigen Abdeckung des Gehäuses dient. Die Gehäusekappe geht also einstückig vom frontseitigen Abschnitt in den randseitigen Abschnitt über, das heißt ohne irgendwelche Kanten und Vorsprünge.

Die erfindungsgemäße Bedieneinrichtung ist als Griff ausgebildet. Um diesem Zweck zu genügen, ist gemäß einem Merkmal der Erfindung vorgesehen, dass das Gehäuse einen Greifabschnitt aufweist, der verwenderseitig als Handhabe dient. Dieser Greifabschnitt ist bevorzugterweise an einer im geschlossenen Zustand der Tür unteren Randkante des Gehäuses ausgebildet. Gegebenenfalls wird vom Gehäuse auch eine Griffmulde bereitgestellt. Verwenderseitig kann die Bedieneinrichtung jedenfalls für eine bestimmungsgemäße Verschwenkbewegung der Tür des Herdes, des Damfgarers, der Wäschebehandlungs- oder Spülmaschine ergriffen werden.

Das Gehäuse weist gemäß einem weiteren Merkmal der Erfindung türseitig Hakenelemente auf. Diese Hakenelemente dienen der Anordnung der Bedieneinrichtung an der Tür des Herdes, des Dampfgarers, der Wäschebehandlungs- oder Spülmaschine. Die Tür des Herdes, des Dampfgarers, der Wäschebehandlungs- oder Spülmaschine verfügt über zu den Hakenelementen des Gehäuses korrespondierend ausgebildete Ausnehmungen. In diese ist die Bedieneinrichtung dank ihrer am Gehäuse ausgebildeten Hakenelemente im endmontierten Zustand eingehakt und in ihrer relativen Lage gegenüber der Tür lagefixiert. Um ein ungewolltes Aushaken zu unterbinden, können weitere, vorzugsweise lösbare Befestigungsmittel, insbesondere Schrauben, zum Einsatz kommen.

Weitere Merkmale und Vorteile der Erfindung ergeben sich aus der nachfolgenden Beschreibung anhand der Figuren. Dabei zeigen:
- Fig. 1: in schematischer Frontansicht die Tür einer Spülmaschine mit einer daran frontseitig angeordneten Bedieneinrichtung nach der Erfindung;
- Fig. 2: in einer schematischen Seitenansicht die Tür nach Fig. 1;
- Fig. 3: in schematischer Detailansicht die Bedieneinrichtung nach der Erfindung gemäß Schnittlinie III-III nach Fig. 1;
- Fig. 4: in schematischer Detailansicht die Bedieneinrichtung nach der Erfindung gemäß Schnittlinie IV-IV nach Fig. 1;
- Fig. 5: in einer schematischen Explosionsdarstellung die erfindungsgemäße Bedieneinrichtung;

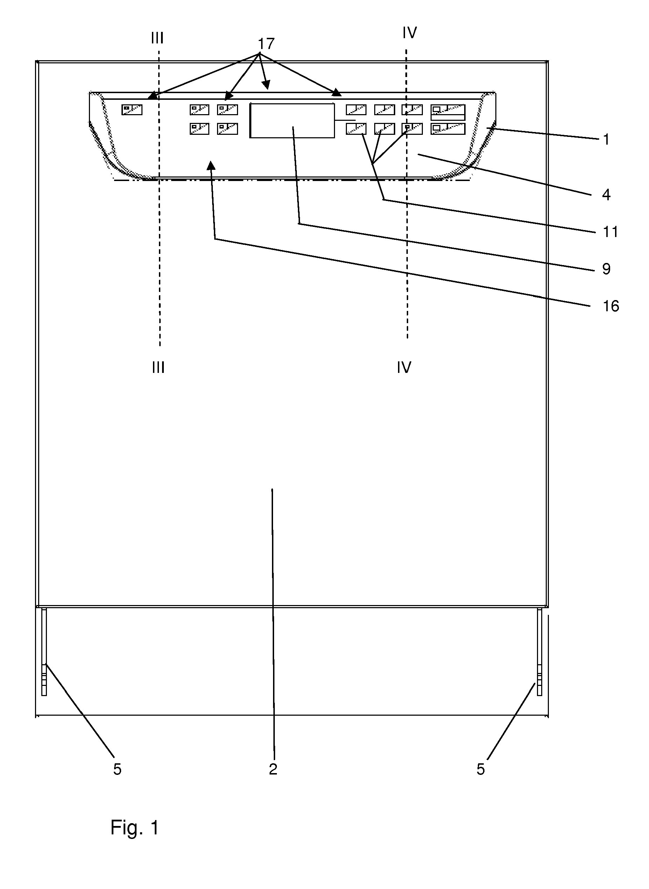

Figur 1 lässt in einer schematischen Frontansicht die Tür 2 einer in den Figuren nicht näher dargestellten Spülmaschine erkennen. Die Tür 2 trägt frontseitig eine Bedieneinrichtung 1 nach der Erfindung.

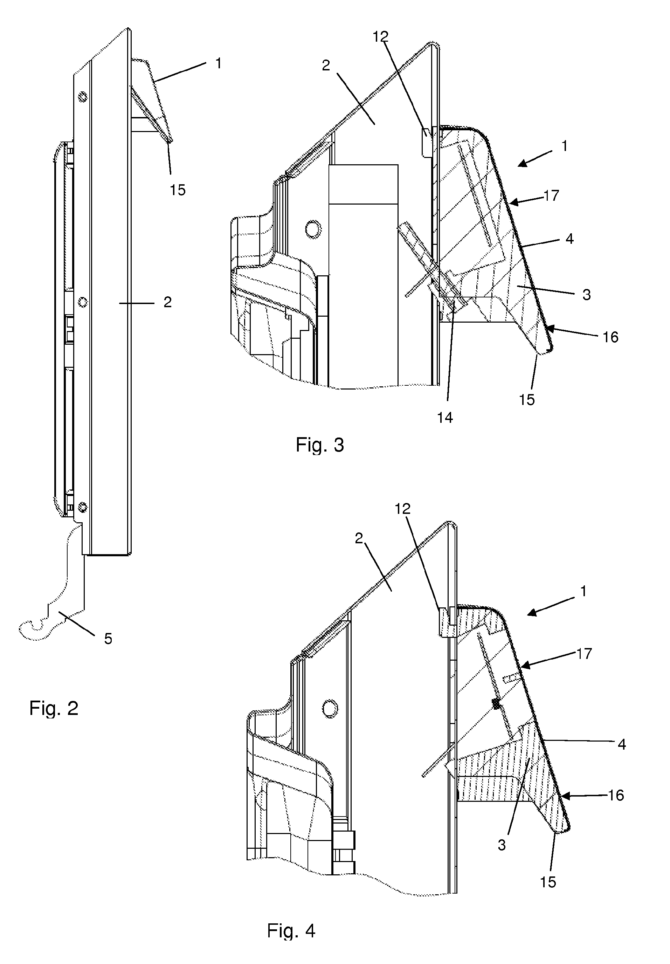

Wie insbesondere eine Zusammenschau der Figuren 1 und 2 erkennen lässt, ist die Tür 2 mit Gelenkarmen 5 ausgestattet, die der verschwenkbaren Anordnung der Tür 2 an einem in den Figuren nicht näher dargestellten Korpus einer Spülmaschine dienen. Die Bedieneinrichtung 1 ist als Griff ausgebildet, so dass sie im endmontierten Zustand von einem Verwender zwecks einer bestimmungsgemäßen Verschwenkung der Tür 2 ergriffen werden kann.

Die Bedieneinrichtung 1 stellt, wie insbesondere Figur 1 entnommen werden kann, frontseitig ein Bedienfeld 17 bereit. Im dargestellten Ausführungsbeispiel umfasst das Bedienfeld 17 eine Mehrzahl von Bedienelementen 11 einerseits und ein Anzeigendisplay 9 andererseits.

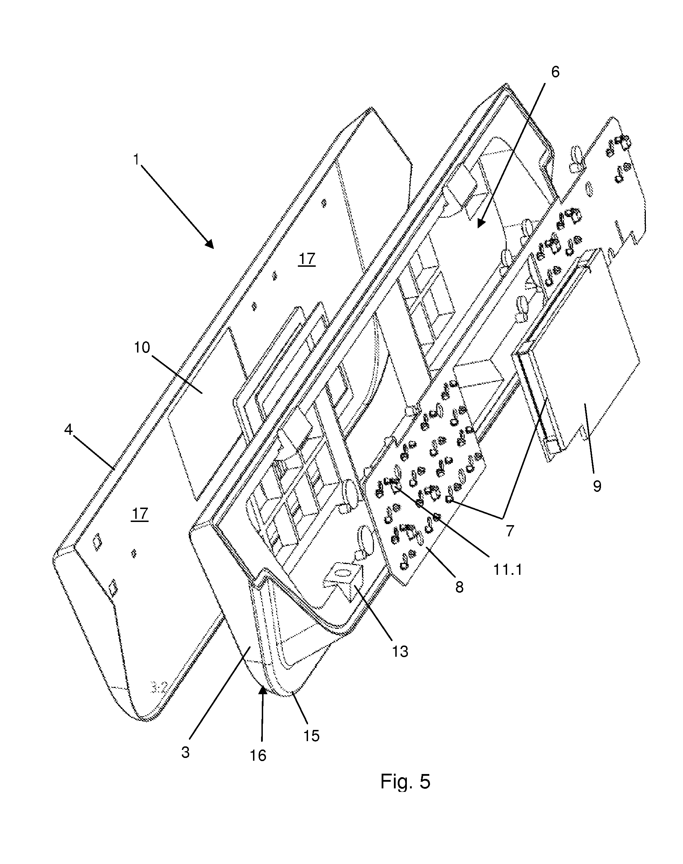

Die erfindungsgemäße Bedieneinrichtung 1 verfügt über ein Gehäuse 3 und eine Gehäusekappe 4, wie insbesondere die Darstellung nach den Figuren 3 bis 5 erkennen lässt. Das Gehäuse 3 ist bevorzugterweise als einstückiges Kunststoffspritzgussteil ausgebildet. Die Gehäusekappe 4 besteht hingegen aus Edelstahl, vorzugsweise einem dünnen Edelstahlblech. Im endmontierten Zustand deckt die Gehäusekappe 4 das Gehäuse 3 sowohl front- als auch randseitig zumindest teilweise ab, wie dies die Explosionsdarstellung nach Figur 5 und die Schnittdarstellungen nach den Figuren 3 und 4 zeigen.

Das Gehäuse 3 weist an seiner, mit Bezug auf die Zeichnungsebene nach Figur 2, unteren Gehäusekante 15 einen Greifabschnitt 16 auf. Aufgrund dieser Ausgestaltung kann die Bedieneinrichtung 1 als Griff für einen Verwender dienen.

Das Gehäuse 3 stellt ferner einen Aufnahmeraum 6 bereit, wie in Figur 5 dargestellt ist. Dieser dient der Aufnahme von Elektronikbauteilen 7, wie zum Beispiel einer Leiterplatte 8 und eines Anzeigendisplays 9. Die Leiterplatte 8 ist ihrerseits mit Sensoren 11.1 von Bedienelementen 11 bestückt, die in erfindungsgemäßer Weise als berührungsempfindliche Bedienelemente 11 ausgebildet sind.

Die Gehäusekappe 4 weist frontseitig eine Ausnehmung 10 auf. In diese ist im endmontierten Zustand das Anzeigendisplay 9 eingesetzt, und zwar bedienerseitig bündig, wie insbesondere die Schnittdarstellungen nach den Figuren 3 und 4 erkennen lassen.

Zur Anordnung der Bedieneinrichtung 1 an der Tür 2 stellt das Gehäuse 3 der Bedieneinrichtung 1 türseitig Hakenelemente 12 zur Verfügung. Diese greifen im endmontierten Zustand in korrespondierend hierzu ausgebildete Ausnehmungen der Tür 2 ein, wie sich insbesondere aus den Figuren 3 und 4 ergibt.

Zur lagegesicherten Anordnung der Bedieneinrichtung 1 an der Tür 2 dienen neben den vorgenannten Hakenelementen 12 zusätzliche Befestigungsmittel, die im gezeigten

Ausführungsbeispiel als Schrauben 14 ausgebildet sind. Diese durchgreifen im endmontierten Zustand vom Gehäuse 3 bereitgestellte Lager 13 und sind in entsprechend ausgebildete Gewindebohrungen der Tür 2 eingesetzt. Dieser Sachzusammenhang ergibt sich insbesondere aus der Darstellung nach den Figuren 3 und 5.

Die erfindungsgemäße Ausgestaltung erbringt in vorteilhafter Weise ein mit einer glatten Oberfläche ausgestaltetes Bedienfeld 17. Diese Oberfläche kann sehr gut und ohne Rückstände gereinigt werden und ist aufgrund des eingesetzten Edelstahlmaterials darüber hinaus auch beständig gegenüber chemischen Reinigern und/oder Desinfektionsmitteln. Die Bedienelemente 11 sind berührungsempfindlich ausgebildet und können über eine einfache Berührung der Edelstahloberfläche des Bedienfeldes 17 betätigt werden. Es lässt sich insofern von "Touch durch Edelstahl" sprechen.

## Patentansprüche

1. Bedieneinrichtung (1) für Haushaltgeräte, wie Herde, Dampfgarer, Wäschebehandlungs-oder Spülmaschinen, die als Griff ausgebildet und frontseitig an einer zum Verschließen einer Beschickungsöffnung der Wäschebehandlungs- oder Spülmaschine vorgesehenen Tür (2) anordbar ist, mit einem Gehäuse (3) und einer Gehäusekappe (4) aus Edelstahl, wobei das Gehäuse (3) von der Gehäusekappe (4) bedienerseitig abgedeckte Bedienelemente (11) bereitstellt, die als berührungsempfindliche Bedienelemente (11) ausgebildet sind.

2. Bedieneinrichtung (1) nach Anspruch 1,
**dadurch gekennzeichnet,**
**dass** das Gehäuse (3) einen Aufnahmeraum (6) aufweist, der der Aufnahme von Sensoren (11.1) der Bedienelemente (11), von Elektronikbauteilen (7) und/oder dergleichen dient.

3. Bedieneinrichtung (1) nach Anspruch 2,
**dadurch gekennzeichnet,**
**dass** die Bedienelemente (11) piezoelektrische oder kapazitive Bedienelemente (11) sind.

4. Bedieneinrichtung (1) nach einem der vorhergehenden Ansprüche,
**dadurch gekennzeichnet,**
**dass** das Gehäuse (3) einen als Handhabe dienenden Greifabschnitt (16) aufweist.

5. Bedieneinrichtung (1) nach Anspruch 4,
**dadurch gekennzeichnet,**
**dass** der Greifabschnitt (16) an einer im geschlossenen Zustand der Tür (2) unteren Gehäusekante (15) des Gehäuses (3) ausgebildet ist.

6. Bedieneinrichtung (1) nach einem der vorhergehenden Ansprüche,
**dadurch gekennzeichnet,**
**dass** das Gehäuse (3) türseitig Hakenelemente (12) trägt.

7. Bedieneinrichtung (1) nach einem der vorhergehenden Ansprüche,
**dadurch gekennzeichnet,**
**dass** die Gehäusekappe (4) das Gehäuse (3) sowohl front- als auch randseitig zumindest teilweise abdeckt.

8. Bedieneinrichtung (1) nach einem der vorhergehenden Ansprüche,
**dadurch gekennzeichnet,**
**dass** die Gehäusekappe (4) frontseitig eine Ausnehmung (10) aufweist.

9. Bedieneinrichtung (1) nach Anspruch 8,
**dadurch gekennzeichnet,**
**dass** in der Ausnehmung (10) ein Anzeigendisplay (9) angeordnet ist.

10. Haushaltgerät, wie Herd, Dampfgarer, Wäschebehandlungs- oder Spülmaschine, mit einer Beschickungsöffnung, die mittels einer Tür (2) verschließbar ist, wobei die Tür (2) frontseitig eine Bedieneinrichtung (1) nach einem der vorhergehenden Ansprüche 1 bis 9 aufweist.
